# EUROPÄISCHE PATENTANMELDUNG

(11) **EP 4 546 957 A1**
(43) Veröffentlichungstag der Anmeldung: **30.04.2025**
(21) Anmeldenummer: 24206697.5
(22) Anmeldetag: 15.10.2024
(51) Int. Cl.: H05K 5/00, H05K 5/03, H05K 5/06

(54) **STANDARDGEHÄUSE MIT DECKEL AUS EINEM TRANSPARENTEN ODER TRANSLUZENTEN MATERIAL**

(30) Priorität: 25.10.2023 DE 102023129460
(71) Anmelder: bopla Gehäuse Systeme GmbH, 32257 Bünde (DE)
(72) Erfinder: Krömer, Andreas, 32425 Minden (DE)
(74) Vertreter: Weeg, Thomas

(57) **Zusammenfassung**

Die vorliegende Erfindung bezieht sich auf ein Standardgehäuse (2) für den Einbau von elektrischen und/oder elektronischen Komponenten mit einem Unterteil (4) als einem ersten Gehäusebauteil und einem den Gehäuseinnenraum (8) nach außen schließenden Deckel (6) als einem zweiten Gehäusebauteil.

Um Teile des Standardgehäuses (2) ohne gesonderte Bearbeitungen leuchtend ausgestalten zu können, wird vorgeschlagen, dass das Unterteil (4) aus einem nicht transparenten und nicht transluzenten Material und der Deckel (6) aus einem transparenten oder transluzenten Material hergestellt sind, wobei auf den Deckel (6) eine aus einem nicht transparenten und nicht transluzenten Material hergestellte Haube (14) aufgesetzt ist, die den Deckel (6) zumindest bereichsweise oder vollständig überdeckt.

## Beschreibung

Die vorliegende Erfindung bezieht sich auf ein Standardgehäuse für den Einbau von elektrischen und/oder elektronischen Komponenten nach dem Oberbegriff des Anspruchs 1.

Aus der Schrift EP 2 587 901 A2 ist ein gattungsgemäßes Standardgehäuse bekannt. Standardgehäuse werden genutzt, um elektrische oder elektronische Komponenten gegen Umwelteinflüsse geschützt in beliebigen Anwendungen verbauen zu können. Die Anwender der Standardgehäuse wählen für Ihre Anwendung ein geeignetes Standardgehäuse aus einer angebotenen Produktpalette aus und sparen sich dadurch Werkzeugkosten für ein eigenes Gehäuse. Bei einer entsprechend breiten Produktpalette lässt sich für nahezu jede Anwendung ein geeignetes Standardgehäuse finden.

Die Standardgehäuse sind so konfiguriert, dass sie häufig ein Unterteil aufweisen, in dessen Gehäuseinnenraum die elektrischen und/oder elektronischen Komponenten eingebaut werden können. Auf das Unterteil wird nach dem Einbau der elektrischen und/oder elektronischen Komponenten ein Deckel aufgesetzt, durch den der Gehäuseinnenraum geschlossen ist und die darin angeordneten elektrischen und/oder elektronischen Komponenten gut vor Umwelteinflüssen von außen geschützt sind. Um die Standardgehäuse an individuelle Anforderungen anzupassen, ist es möglich, daran individuelle Bearbeitungen vorzunehmen. So können die Standardgehäuse mechanisch bearbeitet werden, beispielsweise durch Fräsen, Bohren, Schneiden, Sägen oder Ultraschallschweißen. Es können auch Oberflächen veredelt werden, beispielsweise durch Digitaldruck, Laserbeschriftung, Sieb- und Tampondruck, Gravuren, Lackierung oder Beschichtungen. Es ist außerdem möglich, Touch- und Displayflächen, Kabeldurchführungen oder Bedienknöpfe am Standardgehäuse anzubringen. Auf diese Weise können die Standardgehäuse an individuelle Anforderungen eines Anwenders angepasst werden.

Um die bekannten Standardgehäuse mit Lichteffekten zu versehen, ist es möglich, geeignete Lichtquellen außen auf das Standardgehäuse aufzusetzen oder den Deckel aufzufräsen und/oder aufzubohren, damit das Licht, das im Gehäuseinnenraum angeordnete Lichtquellen erzeugen, nach außen fallen kann. Der Nachteil einer solchen Lösung ist darin zu sehen, dass der Deckel dabei mit einer Öffnung versehen wird, die nachträglich durch zusätzliche Bearbeitungsgänge wieder verschlossen und abgedichtet werden muss, um die Schutzfunktion des Standardgehäuses wieder herzustellen. Wenn ein Blick von außen auf im Gehäuseinnenraum befindliche Bauteile notwendig ist, können auch Sichtfenster oder Glasabdeckungen in Standardgehäuse eingebaut werden, auch das ist allerdings aufwendig. Es treten erhebliche Schwierigkeiten hinsichtlich der Maßgenauigkeit, Dichtheit und mechanischen Belastbarkeit solcher Fenster auf.

Vor diesem Hintergrund ist es die Aufgabe der vorliegenden Erfindung, eine Lösung zu schaffen, mit der Standardgehäuse mit Lichteffekten und/oder einer Einblickmöglichkeit versehen werden können, ohne dass dadurch umfangreiche zusätzliche Bearbeitungsgänge zum Öffnen, Verschließen und Abdichten des Deckels erforderlich werden.

Die Aufgabe wird für ein gattungsgemäßes Standardgehäuse gelöst durch die kennzeichnenden Merkmale des Anspruchs 1.

Unter Standardgehäusen werden Gehäuse verstanden, die nicht für ein bestimmtes Produkt entworfen wurden und hergestellt werden, sondern für eine Vielzahl von Anwendungen, bei denen sich ein Anwender aus einer Anzahl von angebotenen Standardgehäusen ein für seinen Anwendungsfall passendes Standardgehäuse aussucht und seine Elektrik und/oder Elektronik in dieses Standardgehäuse einbaut. An dem Standardgehäuse können noch Modifikationen vorgenommen werden, um dieses an einen Anwendungsfall anzupassen, es bleibt aber bei den Standardbauteilen, mit denen das Standardgehäuse angeboten wird. Als Standardgehäuse kommen Hand-, Tisch-, Pult- und Wandgehäuse in Betracht. Anwendung finden Standardgehäuse beispielsweise in der Medizintechnik, dem Maschinenbau, dem Gebäudemanagement und der Agrartechnik. In diesen Bereichen werden häufig kleine Produktserien hergestellt, für deren Elektrik und Elektronik sich das Design und die Herstellung von individuellen Gehäusen mit teuren Spezialwerkzeugen nicht lohnt.

Wenn das Unterteil aus einem nicht transparenten und nicht transluzenten Material hergestellt ist, sind die elektrischen und elektronischen Komponenten auf eine bekannte Weise in das Standardgehäuse eingebaut und dort entsprechend geschützt.

Durch das nicht transparente und nicht transluzente Material des Unterteils sind die Komponenten dort von außen nicht sichtbar, und es kann auch kein im Inneren des Standardgehäuses erzeugtes Licht durch die Wände des Unterteils nach außen dringen.

Wenn von einem Unterteil die Rede ist, so ist das nur im Sinne eines unbestimmten Artikels zu verstehen. Es können natürlich auch mehrere Bauteile zu einem Unterteil eines Standardgehäuses zusammengesetzt werden, die dann zusammen ein einziges funktionales Unterteil bilden.

Wenn der Deckel aus einem transparenten oder transluzenten Material hergestellt ist, besteht in diesem Bereich die Möglichkeit, Licht aus dem Gehäuseinnenraum nach außen treten zu lassen. Dabei ist es gleichgültig, welche Lichtquelle zur Erzeugung von Licht im Gehäuseinnenraum verwendet wird. Beispielsweise können also Glühlampen, Halogenglühlampen, Gasentladungs- und Leuchtstofflampen, Leuchtdioden oder LED-Lampen oder auch entsprechend hell leuchtende Displays verwendet werden.

Das Licht der Lichtquelle kann den gesamten Innenraum des Standardgehäuses ausleuchten, oder es ist auf bestimmte Bereiche ausgerichtet, die gezielt beleuchtet werden sollen. Bestimmte Bereiche des Gehäuseinnenraums können auch gegen das Licht aus einer Lichtquelle abgeschirmt sein, um zu verhindern, dass in dem abgeschirmten Bereich Licht von der Lichtquelle nach außen fällt. Im abgeschirmten Bereich kann auch eine zweite Lichtquelle angeordnet sein, deren Licht nicht durch das Licht der abgeschirmten ersten Lichtquelle gestört werden soll.

Es ist es auch möglich, Licht von außen in das Standardgehäuse einfallen zu lassen, und bei der Verwendung eines transparenten Materials ist es auch möglich, von au-βen in den Gehäuseinnenraum hinein zu sehen.

Um diese Funktionen zu ermöglichen, ist es nicht erforderlich, nachträglich irgendwelche Ausfräsungen oder Bohrungen in den Deckel einzubringen, die danach wieder mit gesonderten Bauteilen und einem erheblichen Arbeitsaufwand wieder verschlossen werden müssen. Der Deckel wird bei der Montage einer Elektrik oder Elektronik auf herkömmliche Weise auf das Unterteil aufgesetzt, um das Standardgehäuse nach der Montage der Elektrik/Elektronik zu verschließen. Das Standardgehäuse mit dem aufgesetzten Deckel ist dadurch auf herkömmliche Weise und ohne zusätzliche Bearbeitungen dicht, und der Gehäuseinnenraum ist auf bekannte Weise gegen Umwelteinflüsse von außen wie Schmutz, Staub, Feuchtigkeit, Beschädigungen und Eingriffe von außen geschützt, wobei nun aber der Austausch von Licht von innen nach außen und umgekehrt sowie einen Einblick in den Gehäuseinnenraum schon vom Standardgehäuse her ohne weitere Bearbeitungen möglich ist. Über die Kombination des Deckels mit dem Unterteil und die Ausgestaltung der Schnittstellen dieser Bauteile, beispielsweise mit entsprechenden Dichtungen, können so auch verschiedene Stufen eines IP-Schutzes auf herkömmliche Weise realisiert werden.

Der Deckel kann ein Standard-Bauteil eines Standardgehäuses bleiben, das die Licht- und Durchblickfunktion ohne zusätzliche Bearbeitungen ermöglicht. Der Deckel kann grundsätzlich eine beliebige geeignete Form haben. Der Deckel kann mit gerundeten oder eckig ausgebildeten Kanten versehen sein. Ein Deckel kann plane oder konvex oder konkav geformte Flächen aufweisen. In die Form des Deckels können Formelemente eingeformt sein, die der Verbindung des Deckels mit dem Unterteil und/oder der Haube dienen. Als derartige Formelemente kommen beispielsweise Federn oder Nuten, Klemmelemente, Rastnasen, Gewinde, Schraublöcher, Wellen und Lager für Gelenkverbindungen und dergleichen in Betracht. In den Deckel können auch weitere Funktionsteile eingearbeitet sein, insbesondere in einer einstückigen Ausführung, wie beispielsweise Folienscharniere, Dichtungselemente und dergleichen. Die Einarbeitung von Dichtungen kann beispielsweise auch über ein 2-Komponenten-Spritzgussverfahren oder über ein Einschäumen einer Dichtungsmasse erfolgen, wobei das auch beim Unterteil möglich ist. Dichtungen können aber auch als Rundschnur in entsprechende Ausnehmungen eingelegt werden, bevor die Bauteile zusammengefügt werden.

Wenn von einem Deckel die Rede ist, so ist das nur im Sinne eines unbestimmten Artikels zu verstehen. Es können natürlich auch mehrere Bauteile zu einem Deckel eines Standardgehäuses zusammengesetzt werden, die dann zusammen einen einzigen funktionalen Deckel bilden.

Selbstverständlich kann der aus einem transparenten oder transluzenten Material hergestellte Deckel bei Bedarf für einen konkreten Anwendungsfall individuell bearbeitet werden, wenn das für die Anwendung erforderlich erscheint. So kann auch ein solcher Deckel insbesondere mechanisch bearbeitet, oberflächenveredelt und/oder mit weiteren Anbauteilen wie Tastaturen, Touchflächen, Displays, Kabeldurchführungen und dergleichen versehen sein.

Der transparente oder transluzente Deckel ermöglicht völlig neue Funktionen. Wenn die in den Gehäuseinnenraum eingebaute Elektrik oder Elektronik beispielsweise farbige LEDs aufweist, die jeweils rot oder grün leuchten können oder über eine Farbwechselsteuerung verfügen, mit denen diese Farben einstellbar sind, ist es möglich, durch das wahlweise Einschalten der im Gehäuseinnenraum angeordneten roten oder grünen LED nach außen zu signalisieren, ob sich die Elektrik oder Elektronik in einem störungsfreien Betriebszustand befindet oder ob aktuell eine Störung besteht. Wenn nun zumindest Teilflächen des Gehäuses im Bereich des Deckels je nach geschalteter LED grün oder rot leuchten, ist es für einen Bediener möglich, schon von weitem und auch von der Seite her oder aus der Ferne entsprechende Betriebszustände zu erkennen, ohne dass der Bediener dafür Meldungen auf einem Display, das auf dem Standardgehäuse montiert sein kann, wahrnehmen und lesen muss. Andere Farben oder eine andere Anzahl von Lichtquellen, auch für andere Funktionen, sind natürlich möglich. Der Normalbetrieb einer Maschine, die von einer in das Standardgehäuse eingebauten Elektronik gesteuert wird, kann beispielsweise durch ein grün pulsierendes Licht oder ein Licht in einer anderen Farbe signalisiert werden. Das Licht kann von einer im Gehäuseinnenraum angeordneten Lichtquelle erzeugt werden und durch den Deckel aus transparentem oder transluzentem Material nach außen strahlen. Von einer Lichtquelle mit einer Farbwechselsteuerung können beispielsweise unterschiedliche Signale gegeben werden, beispielsweise können Betriebstemperaturen einer Maschine, Vorratsmengen eines Rohstoffs in einem Bunker, Betriebsdrücke in einem druckbetriebenen Maschinensystem und dergleichen über entsprechend unterschiedliche Farben signalisiert werden. Störungen oder gefährliche Betriebszustände einer Maschine, die von einer im Standardgehäuse angeordneten Elektronik gesteuert wird, können beispielsweise durch Lichtblitze signalisiert werden, die von einer im Gehäuseinnenraum befindlichen Lichtquelle erzeugt werden. Bedieneingaben eines Bedieners der im Gehäuseinneren angeordneten Elektronik können über Lichtsignale quittiert werden, indem Teile des Standardgehäuses kurz von innen her und durch den Deckel von außen sichtbar mit einer Lichtquelle beleuchtet werden.

Über den aus einem transparenten oder transluzenten Material hergestellten Deckel können aber noch weitere Funktionen abgedeckt werden. So kann mit einem durch den Deckel nach außen aus dem Standardgehäuse austretenden Licht eine Notbeleuchtung im Umgebungsbereich des Standardgehäuses bei Stromausfällen realisiert werden. Wenn ein Anwender bei seiner Corporate Identity bestimmte Firmenfarben verwendet, kann der Deckel mit entsprechenden Farben von innen her angestrahlt werden, um das Standardgehäuse als ein originäres Produkt des Anwenders erscheinen zu lassen. Die teilweise leuchtenden Flächen eines Standardgehäuses können auch dazu genutzt werden, das Standardgehäuse in seiner Anwendung insgesamt wertiger erscheinen zu lassen. Weitere Funktionen eines transparenten oder transluzenten Deckels sind denkbar.

Über den Deckel aus einem transparenten oder transluzenten Material kann also das Standardgehäuse in ein Bedienkonzept einer im Gehäuseinnenraum befindlichen Elektrik oder Elektronik integriert werden, ohne dass es dazu gesonderter Bearbeitungen des Standardgehäuses bedarf. Lichtquellen, die sich im Gehäuseinnenraum befinden und ein Bestandteil der dort eingebauten Elektrik oder Elektronik sind, werden von dieser gesteuert. Es ist auch möglich, die im Gehäuseinnenraum befindlichen Lichtquellen von außen her zu steuern, die Stellbefehle für die Lichtquelle können dann über ein Kabel oder drahtlos an die Lichtquelle übertragen werden. Die Signalisation von Betriebszuständen einer Maschine oder eines anderen Geräts, mit dem das Standardgehäuse verbunden ist, kann über den Lichtaustritt zumindest über Teilflächen des Standardgehäuses sogar deutlich verbessert werden, weil die Wahrnehmbarkeit von leuchtenden Flächen besser ist als diejenige von Symbolen oder Texten auf einem Display. Die Transparenz und/oder Transluzenz des Deckels kann aber auch einfach dazu genutzt werden, die Optik eines Standardgehäuses aufzuwerten.

Wenn im Rahmen der Erfindung von einem transparenten oder transluzenten Material die Rede ist, so kann dafür beispielsweise ein geeigneter Kunststoff verwendet werden. So kommt als Material beispielsweise Acryl (PMMA), Polycarbonat (PC) , Polyethylenterephthalat-Glycol (PETG), Polystyrol (PS) oder Hart-PVC (PVC-U) in Betracht, das sowohl als transparentes als auch als transluzentes Material verfügbar ist und in entsprechenden Maschinen und Werkzeugen zu geeignet geformten Deckeln verarbeitet werden kann. Das Material kann farblos und klar gewählt werden, oder es kann mit einer besonderen Färbung oder mit einer Fluoreszenz versehen sein, wenn das von einem Anwender gewünscht ist, um bestimmte Farb- oder Leuchteffekte zu erzielen.

Wenn auf den Deckel eine aus einem nicht transparenten und nicht transluzenten Material hergestellte Haube aufgesetzt ist, die den Deckel zumindest bereichsweise oder vollständig überdeckt, kann über die Gestaltung der Haube bestimmt werden, an welchen Stellen des Deckels Licht aus dem Gehäuseinnenraum durch den Deckel nach außen gelangt oder Licht von außen in den Gehäuseinnenraum leuchtet bzw. eine Person von außen in den Gehäuseinnenraum hinein sehen kann. Die Haube kann an ihren Randkonturen den Deckel ganz oder teilweise übergreifen. Sie kann kleine oder größere Löcher, Ausnehmungen, partielle Verdickungen oder Materialschwächungen aufweisen. Um in einem Baukastensystem mit einem geringen Werkzeugaufwand Designvarianten ausbilden zu können, können verschiedene Hauben mit unterschiedlichen Designs vorgehalten und auf denselben Deckel passend aufsetzbar sein. Das Unterteil und der Deckel bleiben dann gleich, und nur die jeweiligen im Baukastensystem vorgehaltenen Hauben weisen ein unterschiedliches Design auf.

Die Haube kann dazu dienen, technische Funktionselemente, die funktional dem Deckel zugeordnet sind, so zu überdecken, dass sie für den Benutzer des Standardgehäuses nicht sichtbar sind. Als technische Funktionselemente, die in den Deckel integriert sein können, kommen beispielsweise Teile einer Verschraubung, Spannelemente zur Verspannung des Deckels mit dem Unterteil oder Dichtungselemente in Betracht. Wenn die Haube nur oder insbesondere dem Zweck einer gefälligen Optik dient, ist es möglich, die Haube so am Deckel zu befestigen, dass diese werkzeuglos abnehmbar ist, beispielsweise über Rast- und/oder Klemmverbindungen.

Wenn von einer Haube die Rede ist, so ist das nur im Sinne eines unbestimmten Artikels zu verstehen. Es können natürlich auch mehrere Bauteile zu einer Haube eines Standardgehäuses zusammengesetzt werden, die dann zusammen eine Haube bilden.

Die Haube kann nur mit dem Deckel, mit dem Deckel und dem Unterteil oder nur mit dem Unterteil über für sich bekannte Verbindungstechniken verbunden sein. Die Haube schützt den Deckel im Überdeckungsbereich vor Beschädigungen, beispielsweise im besonders beanspruchten Kantenbereich. Die Haube bietet zusätzliche Befestigungsmöglichkeiten für Anbauteile, die insbesondere dann sinnvoll sind, wenn Durchbrechungen des Deckels für den Anbau dieser Anbauteile an das Standardgehäuse vermieden werden sollen.

Die Haube kann wie der Deckel und das Unterteil ein Standardbauteil sein, an dem nachträglich Bearbeitungen vorgenommen werden können. So kann auch eine solcher Haube insbesondere mechanisch bearbeitet, oberflächenveredelt und/oder mit weiteren Anbauteilen wie Tastaturen, Touchflächen, Displays, Kabeldurchführungen und dergleichen versehen sein.

Wenn der Deckel und das Unterteil über ein oder mehrere Spannelemente miteinander verbunden sind, so sind mit den Spannelementen Bauteile gemeint, mit denen der Deckel und das Unterteil in einer Montagestellung zusammengehalten werden. Hier können die üblichen bekannten Spannmittel verwendet werden, wie beispielsweise Schrauben, mit Kniehebeln zusammenwirkende Zuganker, Spannklammern, Spanngelenke und dergleichen.

Nach einer Ausgestaltung der Erfindung ist der Deckel aus einem transparenten Material hergestellt, und Anzeige- und/oder Bedienelemente einer elektrischen oder elektronischen Steuerung und/oder Displays sind auf der Innenseite des Deckels im Gehäuseinnenraum angeordnet. Solche elektrischen oder elektronischen Komponenten sind im Gehäuseinnenraum besonders gut gegen Verschmutzung und Feuchtigkeit geschützt. Durch den transparenten Deckel hindurch sind die entsprechenden Komponenten aber von außen gut einsehbar und bedienbar, insbesondere, wenn die Betätigung der Bedienelemente nicht mechanisch, sondern durch eine sensorisch überwachte Oberfläche erfolgt.

Nach einer Ausgestaltung der Erfindung weist der Deckel und/oder die Haube individuelle Bearbeitungen auf. So können der Deckel und/oder die Haube mechanisch bearbeitet sein, beispielsweise durch Fräsen, Bohren, Schneiden, Sägen oder Ultraschallschweißen. Es können auch Oberflächen veredelt sein, beispielsweise durch Digitaldruck, Laserbeschriftung, Sieb- und Tampondruck, Gravuren, Lackierung oder Beschichtungen. Als eine Form einer individuellen Bearbeitung können auch Folien auf der Innen- oder Außenseite des Deckels angebracht sein. Die Oberflächenveredelung kann ganz allgemein auf der Innen- und/oder Außenseite des Deckels angebracht sein, und sie kann den Deckel auf der Innen- und/oder Außenseite vollflächig oder nur in einer oder mehreren Teilflächen abdecken. Es ist außerdem möglich, Touch- und Displayflächen, Kabeldurchführungen oder Bedienknöpfe am Standardgehäuse anzubringen. Auf diese Weise können die Standardgehäuse an individuelle Anforderungen eines Anwenders angepasst sein.

Nach einer Ausgestaltung der Erfindung weisen der Deckel und/oder die Haube eine plane Teiloberfläche auf. Durch eine plane Teiloberfläche des Deckels ist es insbesondere möglich, dort Bereiche, die vom Material her eigentlich transparent oder transluzent sind, über die Bedruckung so abzudecken, dass dort kein Licht mehr von innen nach außen und umgekehrt durch den Deckel fällt. Die mit einer Bedruckung versehene Oberfläche kann dabei so ausgewählt und gestaltet werden, dass sie an die Bedürfnisse eines konkreten Anwendungsfalls genau individuell angepasst ist. Die plane Fläche ist mit einer hohen Qualität bedruckbar, beispielsweise mit einem Siebdruck oder einem Tampondruck, ohne dass es dabei zu Verzerrungen durch Unebenheiten der zu bedruckenden Oberfläche kommt. Das verwendete transparente oder transluzente Material des Deckels kann so ausgewählt sein, dass es eine dauerhaft haltbare Bedruckung zulässt. Die Bedruckung kann individuell der jeweiligen Anwendung entsprechend ausgestaltet werden. Eine plane Teiloberfläche der Haube kann ebenfalls mit einer für einen konkreten Anwendungsfall geeigneten Bedruckung versehen werden. Die plane Teiloberfläche ist neben der vorteilhaften Bedruckbarkeit auch vorteilhaft, wenn darauf Komponenten einer Elektrik und/oder einer Elektronik eines Anwenders aufgebaut werden sollen. Entsprechende Anbauteile haben häufig plane Oberflächen, die gut auf einer planen Teiloberfläche des Deckels und/oder der Haube montiert werden können.

Nach einer Ausgestaltung der Erfindung weist die Haube eine von den Maßen her zumindest annähernd oder genau zur planen Teiloberfläche des Deckels passende Öffnung auf. Wenn sich die Öffnung in der Haube und eine plane Teiloberfläche des Deckels zumindest annähernd oder genau entsprechen, kann eine Nachbearbeitung einer Haube als Standardbauteil im Bereich der planen Teiloberfläche des Deckels entfallen oder zumindest vom Umfang her verringert werden. Zwar besteht dann das Risiko, dass die Haube als Standardbauteil größere Flächenanteile des Deckels nicht abdeckt, obwohl dort in einer Anwendung eine Abdeckung gewünscht ist. Die dort von der Haube fehlende Abdeckung kann aber leichter und kostengünstiger über eine Bedruckung der in einer Anwendung abzudeckenden planen Teiloberfläche erfolgen. Eine mechanische Nachbearbeitung der Haube als Standardbauteil kann bei einer entsprechenden Dimensionierung der Öffnung entfallen, um das Standardgehäuse an einen Anwendungsfall anzupassen.

Nach einer Ausgestaltung der Erfindung weist der Deckel eine Innenbeschichtung auf. Durch die Innenbeschichtung, wie beispielsweise eine Lackierung, können besondere optische Effekte erzielt werden. Die Innenbeschichtung kann bereichsweise oder vollflächig auf der Innenseite des Deckels angebracht sein. Bei einem transparenten Material, mit dem der Deckel hergestellt ist, kann beispielsweise ein besonders edel und wertig erscheinender Eindruck von gefärbtem Glas erzeugt werden. Die Innenbeschichtung kann aber beispielsweise auch aus einem Material bestehen, das die im Gehäuseinnenraum installierte Elektrik und/oder Elektronik gegen ungewollte elektrische oder elektromagnetische Effekte von außen schützt oder umgekehrt verhindert, dass die im Gehäuseinnenraum installierte Elektrik und/oder Elektronik fremde elektrische oder elektronische Geräte stört.

Nach einer Ausgestaltung der Erfindung weist die Haube eine Gestaltung auf, bei der sowohl auf der Oberseite des Standardgehäuses als auch an zumindest einer in eine seitliche Richtung weisenden Seite des Standardgehäuses Teiloberflächen des Deckels von der Haube nicht abgedeckt sind. Bei einer solchen Ausgestaltung der Haube ist es möglich, Licht nach oben und zur Seite aus dem Standardgehäuse zu strahlen. Wenn eine solche Funktion in einem Anwendungsfall nicht gewünscht ist, können die nicht für den Lichtausfall vorgesehenen Teilflächen durch eine Bedruckung und/oder Lackierung und/oder eine im Gehäuseinneren vorhandene Abschirmung lichtundurchlässig gemacht werden.

Nach einer Ausgestaltung der Erfindung ist das Unterteil aus einem metallischen Werkstoff hergestellt. Ein metallischer Werkstoff verbessert die Abfuhr von Wärme aus dem Gehäuseinnenraum, die dort durch den Betrieb der elektrischen und/oder elektronischen Komponenten entstehen kann. Um eine wärmebedingte chemische Alterung des transparenten und/oder transluzenten Werkstoffs des Deckels zu verlangsamen oder ganz zu verhindern, ist eine möglichst niedrige Innenraumtemperatur im Standardgehäuse vorteilhaft. Auch die elektromagnetische Abstrahlung und Einstrahlung wird durch ein Unterteil aus einem metallischen Werkstoff verringert. Als metallischer Werkstoff ist insbesondere Aluminium vorteilhaft, weil dieser über gute technische Eigenschaften verfügt, leicht be- und verarbeitbar ist und auch langfristig noch gut aussieht.

Nach einer Ausgestaltung der Erfindung ist auf den Deckel eine Haube mit einer partiellen Bearbeitung aufgesetzt. Die partielle Bearbeitung kann insbesondere in einer nach der Herstellung der Haube als Standardbauteil eingebrachten Ausnehmung wie einer Bohrung, einer Ausfräsung oder dergleichen bestehen. Über die partielle Bearbeitung kann die Haube als Standardbauteil an die individuellen technischen Bedürfnisse eines Anwendungsfalls angepasst werden. Insbesondere, wenn die Haube als ein vollständig oder großflächig überwiegend geschlossenes Standard-bauteil ausgeführt ist, können über die partiellen Bearbeitungen in Teilbereichen Öffnungen hergestellt werden, in denen eine Transparenz und/oder Transluzenz in der Anwendung gefordert ist.

Nach einer Ausgestaltung der Erfindung sind die Kontaktflächen der Haube, mit denen die Haube die Oberfläche des Deckels kontaktiert, zumindest bereichsweise kongruent auf der Form der kontaktierenden Oberfläche des Deckels aufliegend ausgestaltet. Dadurch stellt sich in diesen Bereichen in der Gebrauchsstellung der Haube eine spielfreie Auflage der Kontaktflächen der Haube auf dem Deckel ein. Über die gemeinsamen Kontaktflächen können sich die Haube und der Deckel gegenseitig abstützen, so dass dadurch die Festigkeit und Belastbarkeit des Standardgehäuses insgesamt steigt. Die gemeinsamen Kontaktflächen der Haube mit dem Deckel ermöglichen Klebeverbindungen, über die diese Bauteile miteinander verbunden sein können.

Nach einer Ausgestaltung der Erfindung sind die nach außen weisenden Oberflächen des Deckels und der Haube im Anstoßbereich versatzfrei ausgebildet. Durch den glatten Übergang entsteht eine wertige Optik. Das Risiko von Beschädigungen oder der unbeabsichtigten Ablösung der Haube vom Deckel wird dadurch verringert.

Nach einer Ausgestaltung der Erfindung ist die Schutzklasse des Standardgehäuses nicht von der Ausführung der Haube bestimmt. IP-Schutzklassen geben an, wie stark ein Gegenstand gegen das Eindringen von Wasser oder anderen möglichen Einwirkungen von außen geschützt ist. Der sogenannte IP-Code bedeutet International Protection. Wenn die Ausführung der Haube keinen Einfluss auf die IP-Schutzklasse hat, wird diese durch die Ausführung des Deckels und des Unterteils bestimmt. Der Deckel und das Unterteil können beispielsweise nur darauf ausgelegt sein, einen Berührungsschutz zu bieten, was der Schutzklasse IP 40 entspricht. Bei einer solchen Auslegung könnten Dichtungen gegen eindringende Feuchtigkeit überflüssig sein. Bei einem Schutz in der Schutzklasse IP 44 besteht ein Spritzwasserschutz, bei IP 54 ist das Standardgehäuse zusätzlich staubdicht. Für diese höheren Schutzklassen werden üblicherweise Dichtungen verwendet, und auch die Gestaltungen des Unterteils und des Deckels können an eine höhere Schutzklasse angepasst sein. Da die Haube nur auf den Deckel aufgesetzt ist und insbesondere Funktionen der Optik abdeckt, hat sie auf die von einem Standardgehäuse eingehaltene Schutzklasse keinen Einfluss. Die Haube erfüllt insbesondere den Zweck, die optisch nicht ansprechenden Funktionsbereiche des Deckels abzudecken und die Lichttransmission in Deckelbereichen zu verhindern, in denen diese nicht gewünscht ist.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung mit dem Gegenstand des Anspruchs 1 verwendbar, soweit dem keine technischen Hindernisse entgegenstehen.

Die Erfindung wird nun anhand von bevorzugten Ausführungsbeispielen sowie unter Bezugnahme auf die beigefügten Zeichnungen näher erläutert. Es zeigen:
- Fig. 1:: eine Querschnittansicht durch ein Standardgehäuse mit Deckel und geschlossener Haube,
- Fig. 2:: eine Querschnittansicht durch das in Fig. 1 dargestellte Standardgehäuse mit einer im Gehäuse befindlichen Lichtquelle und partiellen Bearbeitungen der Haube,
- Fig. 3:: eine Abwandlung der in Fig. 2 gezeigten Deckel-/Haubenkombination,
- Fig. 4:: eine Querschnittsansicht auf ein Standardgehäuse mit einem im Gehäuseinnenraum angeordneten Display,
- Fig. 5:: eine Querschnittsansicht auf ein Standardgehäuse mit einer Bedruckung,
- Fig. 6:: eine Querschnittsansicht auf ein Standardgehäuse mit einer Kombination einer Bedruckung und einem Display,
- Fig. 7:: eine Variante des in Fig. 6 dargestellten Standardgehäuses,
- Fig. 8:: eine Variante des in Fig. 5 dargestellten Standardgehäuses,
- Fig. 9:: eine Querschnittsansicht auf ein Standardgehäuse mit einer Innenlackierung,
- Fig. 10:: eine Querschnittsansicht auf ein Standardgehäuse mit einer auf eine Ausnehmung in der Haube gerichteten Lichtquelle, und
- Fig. 11:: eine Querschnittsansicht auf ein Standardgehäuse mit einer großen Öffnung in der Haube.

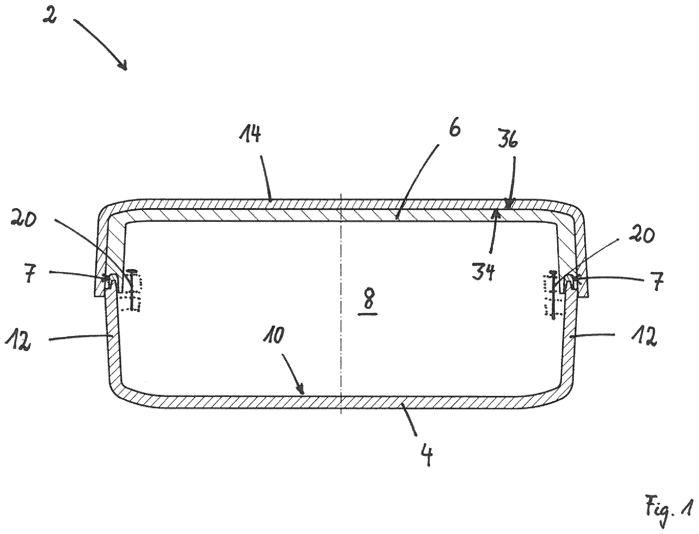

Die Fig. 1 zeigt ein Standardgehäuse 2 mit einem Unterteil 4 als ein erstes Gehäusebauteil, das einen Gehäuseboden 10 und Seitenwände 12 aufweist, die einen Gehäuseinnenraum 8 bodenseitig und zumindest teilweise seitlich umgrenzen. Das Standardgehäuse 2 hat außerdem einen den Gehäuseinnenraum 8 nach außen schließenden Deckel 6 als ein zweites Gehäusebauteil, wobei die ersten und zweiten Gehäusebauteile in der Schließstellung des Deckels 6 über ein oder mehrere Spannelemente 20 miteinander verbunden sind. Im Schnittstellenbereich zwischen dem Deckel 6 und dem Unterteil 4 befindet sich im Ausführungsbeispiel eine Dichtung 7, deren konkrete Ausgestaltung einen Einfluss hat auf die Schutzklasse, die das Standardgehäuse einhält. Die Spannelemente 20 sind im Ausführungsbeispiel Schrauben, die in gepunkteten Linien angedeutete Schraubgewinde eingeschraubt sind. Das Unterteil 4 ist aus einem nicht transparenten und nicht transluzenten Material hergestellt. Der Deckel 6 ist aus einem transparenten oder transluzenten Material hergestellt. Auf den Deckel 6 ist eine aus einem nicht transparenten und nicht transluzenten Material hergestellte Haube 14 aufgesetzt, die den Deckel 6 im gezeigten Ausführungsbeispiel vollständig überdeckt. Bei dieser Ausgestaltung der Haube 14 kann kein Licht aus dem Gehäuseinnenraum 8 nach außen dringen. In der Schnittansicht ist erkennbar, dass die Kontaktflächen 34 der Haube 14, mit denen die Haube 14 die Oberfläche 36 des Deckels 6 kontaktiert, zumindest bereichsweise kongruent auf der Form der kontaktierenden Oberfläche 36 des Deckels 6 aufliegend ausgestaltet.

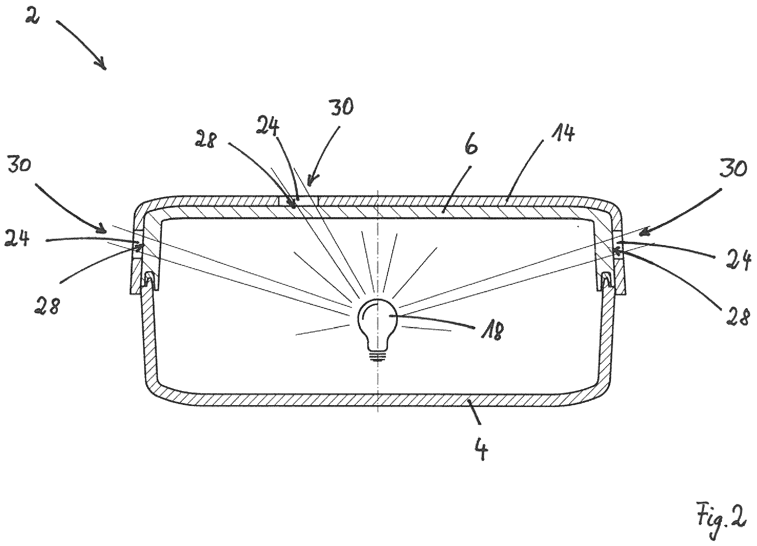

Die Fig. 2 zeigt eine Querschnittansicht durch das in Fig. 1 dargestellte Standardgehäuse 2 mit einer nun im Gehäuseinnenraum 8 befindlichen Lichtquelle 18. Auf den Deckel 6 ist eine Haube 14 mit partiellen Bearbeitungen 30 aufgesetzt. Die Haube 14 weist im Vergleich zu der in Fig. 1 gezeigten Haube 14 nun die partiellen individuellen Bearbeitungen 30 auf, durch die drei verschiedene Öffnungen 24 in die Haube 14 eingebracht worden sind, und zwar eine erste Öffnung 24, die sich auf der Oberseite des Standardgehäuses 2 befindet, sowie zwei weitere Öffnungen 24, die sich an gegenüberliegen Seitenwänden 12 des Standardgehäuses 2 befinden. Da der Deckel 6 aus einem transparenten oder transluzenten Material hergestellt ist, strahlt das von der Lichtquelle 18 erzeugte Licht durch die Öffnungen 24 nach außen, wie durch die entsprechenden Striche angedeutet. Wegen der Öffnungen 24 überdeckt die Haube 14 den Deckel 6 nur noch bereichsweise. Die Haube 14 weist eine Gestaltung auf, bei der sowohl auf der Oberseite des Standardgehäuses 2 als auch an zumindest einer in eine seitliche Richtung weisenden Seite des Standardgehäuses 2 Teiloberflächen 28 des Deckels 6 von der Haube 14 nicht abgedeckt sind.

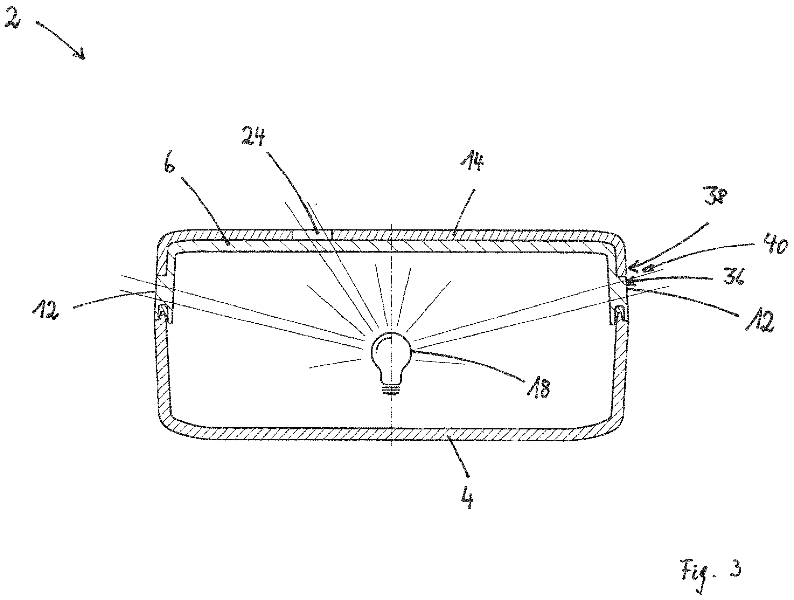

Die Fig. 3 zeigt eine Abwandlung der in den Fig. 1 und 2 gezeigten Deckel-/Haubenkombination. Hier ist der Deckel 6 so ausgeführt, dass er einen Teil der nach außen sichtbaren Seitenwand 12 des Standardgehäuses 2 bildet. Die Haube 14 ist so gestaltet, dass sie den Teil des Deckels 6, der einen Teil der nach außen sichtbaren Seitenwand 12 des Standardgehäuses 2 bildet, nicht überdeckt. Bei dieser Ausgestaltung der Haube 14 kann also von der Lichtquelle 18 erzeugtes Licht aus dem Gehäuseinnenraum 8 nach außen strahlen, ohne dass es einer gesonderten partiellen Bearbeitung der Haube 14 bedarf. Da der Deckel 6 aus einem transparenten oder transluzenten Material hergestellt ist, kann das von der Lichtquelle 18 erzeugte Licht durch die einen Teil der nach außen sichtbaren Seitenwand 12 des Standardgehäuses 2 bildenden Abschnitte des Deckels 6 nach außen strahlen. Die nach au-βen weisenden Oberfläche 36 des Deckels 6 und die nach außen weisende Oberfläche 38 der Haube 14 sind im Anstoßbereich 40 versatzfrei ausgebildet. Auf ihrer Oberseite hat die Haube 14 eine Öffnung 24, durch die ebenfalls von der Lichtquelle 18 erzeugtes Licht durch den Deckel 6 hindurch nach außen strahlt.

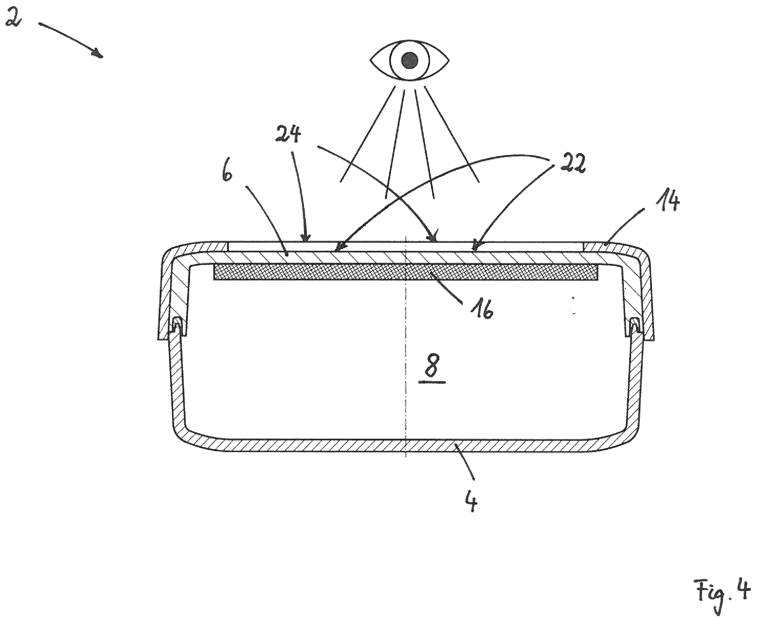

Die Fig. 4 zeigt eine Querschnittsansicht auf ein Standardgehäuse 2 mit einem im Gehäuseinnenraum angeordneten Display 16. Der Deckel 6 weist eine plane Teiloberfläche 22 auf, deren Größe im gezeigten Ausführungsbeispiel annähernd dem aktiven Anzeigebereich des darunter angeordneten Displays 16 entspricht. Da der Deckel 6 aus einem transparenten Material hergestellt ist, kann das Display 16 als ein Beispiel für Anzeige- und/oder Bedienelemente, die auf der Innenseite des Deckels 6 im Gehäuseinnenraum 8 angeordnet sind, gut von außen eingesehen werden, wie durch das stilisierte Auge angedeutet. Das im Gehäuseinnenraum 8 angeordnete Display 16 ist dort vom Deckel 6 gut gegen äußere Einflüsse geschützt. Die Haube 14 weist in diesem Ausführungsbeispiel eine von den Maßen her zumindest annähernd oder genau zur planen Teiloberfläche 22 des Deckels 6 passende Öffnung 24 auf.

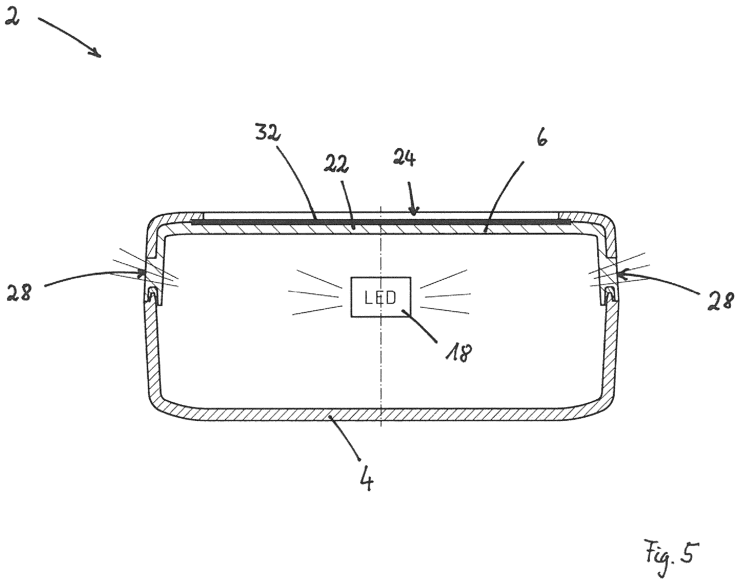

Die Fig. 5 zeigt eine Querschnittsansicht auf ein Standardgehäuse 2 mit einer auf der Außenseite des Deckels 6 angebrachten Bedruckung 32. Im gezeigten Ausführungsbeispiel ist die Bedruckung 32 geschlossen ausgebildet, so dass kein von der Lichtquelle 18 erzeugtes Licht nach oben aus dem Standardgehäuse 2 hinaus strahlt. Die Lichtquelle 18 ist im Ausführungsbeispiel eine LED-Leuchte, deren Licht in Richtung der nicht abgedeckten Teiloberflächen 28 gerichtet ist und durch diese nach außen strahlt.

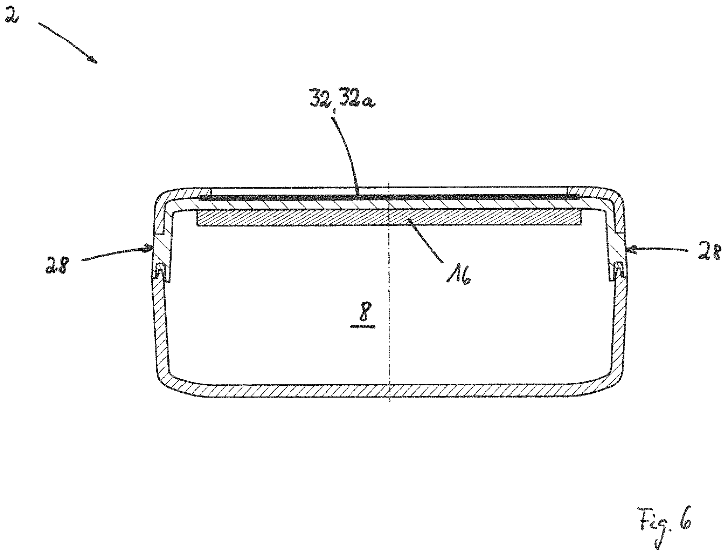

In Fig. 6 ist eine Querschnittsansicht auf ein Standardgehäuse 2 mit einer Kombination einer Bedruckung 32 oder einer Folie 32a und einem Bedienelement 16, wie beispielsweise einem Touchfeld, dass durch den Deckel 6 hindurch bedienbar ist, gezeigt. Die Bedruckung 32 oder die Folie 32a können eine Beschriftung aufweisen, mit der die darunter befindlichen Tastenfelder des Touchfeldes beschriftet sind. In diesem Ausführungsbeispiel des Standardgehäuses 2 ist keine Lichtquelle 18 gezeigt, um darzustellen, dass das Standardgehäuse 2 auch mit einem Deckel 6 aus einem transparenten oder transluzenten Material als ein Standardgehäuse für Anwendungen ohne eine Lichtquelle 18 im Gehäuseinnenraum 8 verwendbar ist. Durch die nicht abgedeckten Teiloberflächen 28 kann dann Licht von außen in den Gehäuseinnenraum 8 fallen.

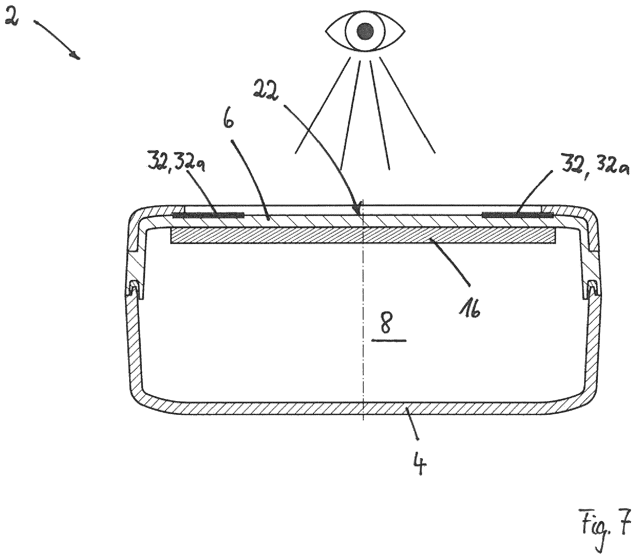

Die Fig. 7 zeigt eine Variante des in Fig. 6 dargestellten Standardgehäuses 2. Die plane Teiloberfläche 22 ist hier nur teilweise mit einer Bedruckung 32/Foliierung 32a versehen. Dadurch sind von außen auch nur Teile des Displays 16 einsehbar.

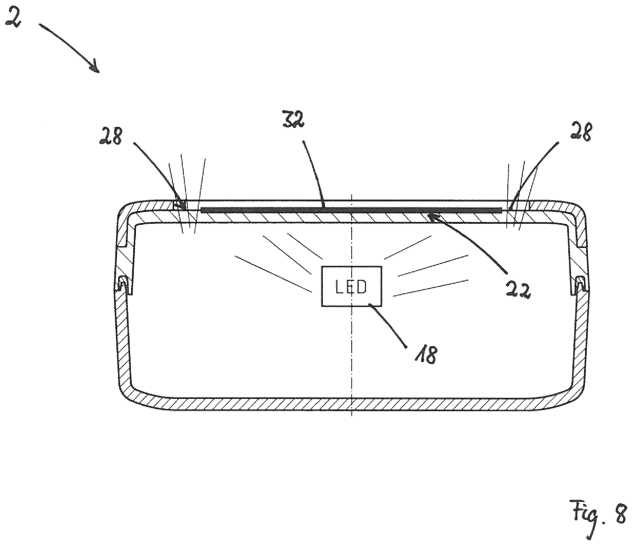

In Fig. 8 ist eine Variante des in Fig. 5 dargestellten Standardgehäuses gezeigt. Von der Bedruckung der planen Teiloberfläche 22 sind die nicht abgedeckten Teiloberflächen 28 ausgenommen, sodass durch diese das von der Lichtquelle 18 erzeugte Licht aus dem Gehäuseinnenraum 8 nach außen fallen kann.

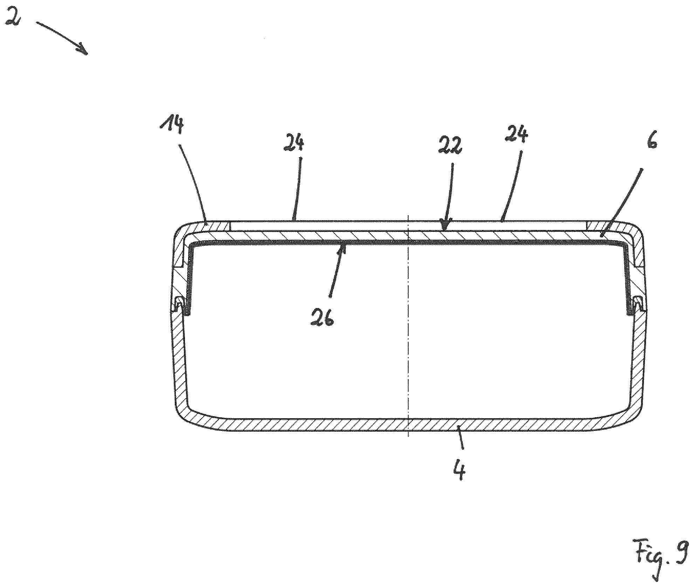

Die Fig. 9 zeigt eine Querschnittsansicht auf ein Standardgehäuse 2 mit einer Innenlackierung des Deckels 6 als Innenbeschichtung 26. Durch die Innenbeschichtung 26 kann kein Licht mehr aus dem Gehäuseinnenraum 8 durch den Deckel 6 nach außen gelangen. Durch die Innenbeschichtung 26 wird der aus einem transparenten oder transluzenten Material hergestellte Deckel 6 intransparent und lässt auch kein Licht mehr hindurchtreten. Das Standardgehäuse 2 kann dadurch trotz des aus einem transparenten oder transluzenten Material hergestellten Deckels 6 wie ein herkömmliches Standardgehäuse 2 mit einem nicht transparenten oder nicht transluzenten Deckel 6 verwendet werden. Durch die Innenbeschichtung 26 ergibt sich aber bei der Betrachtung von außen ein besonders wertig erscheinender optischer Eindruck.

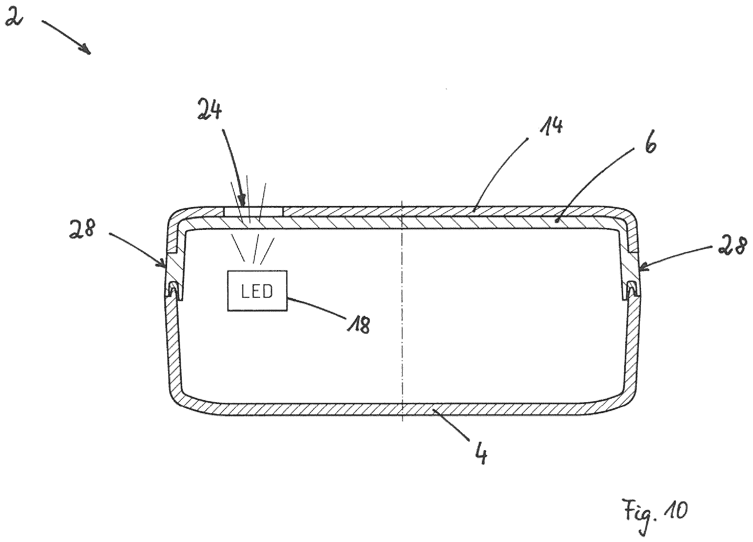

Die Fig. 10 zeigt eine Querschnittsansicht auf ein Standardgehäuse 2 mit einer auf eine Ausnehmung in der Haube 14 gerichteten Lichtquelle 18. Durch die besondere Ausrichtung der Lichtquelle 18 werden die nicht abgedeckten Teiloberflächen 28 von der Lichtquelle 18 nicht beleuchtet, Licht tritt nur durch die Öffnung 24 aus dem Gehäuseinnenraum 8 nach außen ab.

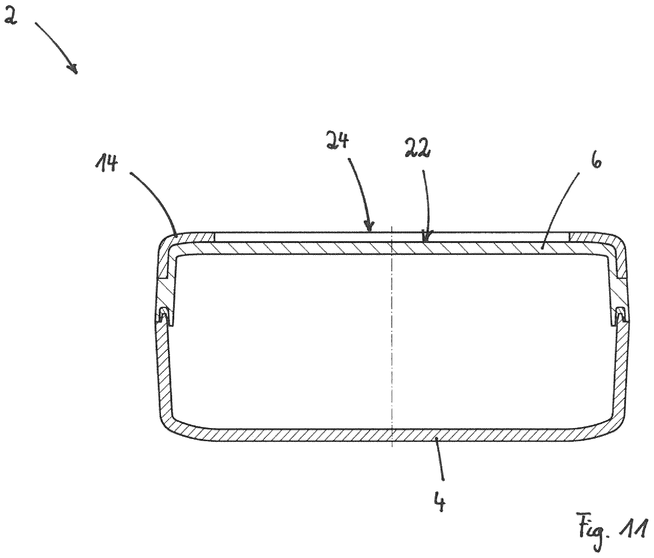

In Fig. 11 ist eine Querschnittsansicht auf ein Standardgehäuse 2 mit einer großen Öffnung in der Haube gezeigt. Auch hier weist die Haube 14 eine von den Maßen her zumindest annähernd oder genau zur planen Teiloberfläche 22 des Deckels 6 passende Öffnung 24 auf.

Bei den Darstellungen handelt es sich im Wesentlichen um konkrete Ausführungsbeispiele. Die Erfindung ist hingegen nicht auf die dargestellten Ausführungsbeispiele beschränkt, sondern kann in fachmännischer Weise abgewandelt werden, um sie an einen bestimmten Anwendungsfall anzupassen.

Soweit dienlich sind in allen Figuren einander entsprechende Bauteile mit identischen Bezugsziffern bezeichnet. Aus Gründen der Übersichtlichkeit sind bei mehrfach auftretenden Bauteilen jedoch nicht stets alle mit Bezugsziffern versehen.

### Bezugszeichenliste

- 2: Standardgehäuse
- 4: Unterteil
- 6: Deckel
- 7: Gehäusedichtung
- 8: Gehäuseinnenraum
- 10: Gehäuseboden
- 12: Seitenwand
- 14: Haube
- 16: Anzeige- und/oder Bedienelemente oder Displays
- 18: Lichtquelle
- 20: Spannelement
- 22: plane Teiloberfläche
- 24: Öffnung
- 26: Innenbeschichtung
- 28: nicht abgedeckte Teiloberfläche
- 30: partielle Bearbeitung
- 32: Bedruckung
- 32a: Foliierung
- 34: Kontaktfläche der Haube
- 36: nach außen weisende Oberfläche des Deckels
- 38: nach außen weisende Oberfläche der Haube
- 40: Anstoßbereich

## Patentansprüche

1. Standardgehäuse (2) für den Einbau von elektrischen und/oder elektronischen Komponenten mit einem Unterteil (4) als ein erstes Gehäusebauteil, das einen Gehäuseboden (10) und Seitenwände (12) aufweist, die einen Gehäuseinnenraum (8) bodenseitig und zumindest teilweise seitlich umgrenzen, und einem den Gehäuseinnenraum (8) nach außen schließenden Deckel (6) als ein zweites Gehäusebauteil, wobei die ersten und zweiten Gehäusebauteile in der Schließstellung des Deckels (6) über ein oder mehrere Spannelemente (20) miteinander verbunden sind, **dadurch gekennzeichnet, dass** das Unterteil (4) aus einem nicht transparenten und nicht transluzenten Material und der Deckel (6) aus einem transparenten oder transluzenten Material hergestellt sind, wobei auf den Deckel (6) eine aus einem nicht transparenten und nicht transluzenten Material hergestellte Haube (14) aufgesetzt ist, die den Deckel (6) zumindest bereichsweise oder vollständig überdeckt.

2. Standardgehäuse (2) nach Anspruch 1, **dadurch gekennzeichnet, dass** der Deckel (6) aus einem transparenten Material hergestellt ist, und Anzeige- und/oder Bedienelemente (16) einer elektrischen oder elektronischen Steuerung und/oder Displays (16) auf der Innenseite des Deckels (6) im Gehäuseinnenraum (8) angeordnet sind.

3. Standardgehäuse (2) nach Anspruch 1 oder 2, **dadurch gekennzeichnet, dass** der Deckel (6) individuelle Bearbeitungen aufweist.

4. Standardgehäuse (2) nach einem der vorhergehenden Ansprüche, **dadurch gekennzeichnet, dass** der Deckel (6) und/oder die Haube (14) eine plane Teiloberfläche (22) aufweisen.

5. Standardgehäuse (2) nach Anspruch 4, **dadurch gekennzeichnet, dass** die Haube (14) eine von den Maßen her zumindest annähernd oder genau zur planen Teiloberfläche (22) des Deckels (6) passende Öffnung (24) aufweist.

6. Standardgehäuse (2) nach einem der vorhergehenden Ansprüche, **dadurch gekennzeichnet, dass** der Deckel (6) eine Innenbeschichtung (26) aufweist.

7. Standardgehäuse (2) nach einem der vorhergehenden Ansprüche, **dadurch gekennzeichnet, dass** die Haube (14) eine Gestaltung aufweist, bei der sowohl auf der Oberseite des Standardgehäuses (2) als auch an zumindest einer in eine seitliche Richtung weisenden Seite des Standardgehäuses (2) Teiloberflächen (28) des Deckels (6) von der Haube (14) nicht abgedeckt sind.

8. Standardgehäuse (2) nach einem der vorhergehenden Ansprüche, **dadurch gekennzeichnet, dass** das Unterteil (4) aus einem metallischen Werkstoff hergestellt ist.

9. Standardgehäuse (2) nach einem der vorhergehenden Ansprüche, **dadurch gekennzeichnet, dass** auf den Deckel (6) eine Haube (14) mit einer partiellen Bearbeitung (30) aufgesetzt ist.

10. Standardgehäuse (2) nach einem der vorhergehenden Ansprüche, **dadurch gekennzeichnet, dass** die Kontaktflächen (34) der Haube (14), mit denen die Haube (14) die Oberfläche (36) des Deckels (6) kontaktiert, zumindest bereichsweise kongruent auf der Form der kontaktierenden Oberfläche (36) des Deckels (6) aufliegend ausgestaltet sind.

11. Standardgehäuse (2) nach einem der vorhergehenden Ansprüche, **dadurch gekennzeichnet, dass** die nach außen weisenden Oberflächen (36, 38) des Deckels (6) und der Haube (14) im Anstoßbereich (40) versatzfrei ausgebildet sind.

12. Standardgehäuse (2) nach einem der vorhergehenden Ansprüche, **dadurch gekennzeichnet, dass** die Schutzart des Standardgehäuses (2) nicht von der Ausführung der Haube (14) bestimmt ist.
